(19) Europäisches Patentamt
European Patent Office
Office européen des brevets

(11) **EP 2 300 859 B1**

(12) **EUROPEAN PATENT SPECIFICATION**

(45) Date of publication and mention
of the grant of the patent:
**13.01.2016 Bulletin 2016/02**

(51) Int Cl.:
*G02B 5/18* ^(2006.01)     *G02B 27/44* ^(2006.01)
*H01S 5/14* ^(2006.01)

(21) Application number: **08761639.7**

(22) Date of filing: **05.05.2008**

(86) International application number:
**PCT/FI2008/050243**

(87) International publication number:
**WO 2009/135982 (12.11.2009 Gazette 2009/46)**

(54) **LIGHT MANIPULATION ARRANGEMENT**

LICHTMANIPULATIONSANORDNUNG

AGENCEMENT DE MANIPULATION DE LA LUMIÈRE

(84) Designated Contracting States:
**AT BE BG CH CY CZ DE DK EE ES FI FR GB GR
HR HU IE IS IT LI LT LU LV MC MT NL NO PL PT
RO SE SI SK TR**

(43) Date of publication of application:
**30.03.2011 Bulletin 2011/13**

(73) Proprietor: **Nanocomp Oy Ltd.
80710 Lehmo (FI)**

(72) Inventor: **LAAKKONEN, Pasi
FI-80140 Joensuu (FI)**

(74) Representative: **Papula Oy
P.O. Box 981
00101 Helsinki (FI)**

(56) References cited:
WO-A1-2007/082952     JP-A- 59 100 404
JP-A- 2005 175 049     US-A1- 2003 214 700
US-A1- 2004 165 639     US-A1- 2007 030 483
US-A1- 2007 223 554     US-A1- 2008 003 528
US-B1- 6 834 069

• LOHMANN A ET AL: "External Cavity Laser With
a Vertically Etched Silicon Blazed Grating", IEEE
PHOTONICS TECHNOLOGY LETTERS, IEEE
SERVICE CENTER, PISCATAWAY, NJ, US, vol.
15, no. 1, 1 January 2003 (2003-01-01),
XP011067486, ISSN: 1041-1135
• MERIMAA ET AL.: 'Compact external-cavity
diode laser with a novel transmission geometry'
OPTICS COMMUNICATIONS vol. 174, no. 1-4, 15
January 2000, pages 175 - 180, XP004186851

EP 2 300 859 B1

**Description**

**FIELD OF THE INVENTION**

The present invention relates to arrangements for dividing the light power of an incident light beam between a reflected beam backwards to the direction of incidence and a transmitted beam. In more detail, the present invention is focused on arrangements utilising a diffraction grating as the light power dividing element. This kind of arrangements are known e.g. for transmission type external cavity diode lasers.

**BACKGROUND OF THE INVENTION**

Tunable wavelength laser sources based on external cavity diode lasers (External Cavity Diode Laser ECDL) are nowadays widely used in different kinds of experiments e.g. in the fields of optical and atomic physics. The standard arrangement to form the external cavity is a so called Littrow configuration where the output of the laser diode is directed to a diffraction grating providing a partial reflection of light into the $R_{-1}$ diffraction order backwards to the direction of incidence, i.e. back to the diode, while the actual output of the system goes to the zeroth diffraction order. The wavelength tuning of the output is typically performed by slightly rotating the grating when the wavelength fulfilling the Littrow condition is changed.

Conventionally, the Littrow configurations were based on reflection type gratings. Later on, due to e.g. the unwanted turning of the output beam while tuning the system Littrow configurations utilising transmission type gratings have been introduced. For example, Merimaa et al reported a transmission type Littrow configuration based on a binary surface relief grating formed onto a $SiO_2$ substrate ("Compact external-cavity diode laser with a novel transmission geometry", Optics Communications 174 (2000), 175 - 180). As another example, Bertani et al introduced a transmission type Littrow configuration involving an elastic grating, the tuning of which being carried out by stretching the grating instead of rotating ("Stretching-tunable external-cavity laser locked by an elastic silicone grating", Optics Express, Vol. 14, No. 25, 11982 - 11986).

US2007/0223554 discloses a diffraction grating in a transmission type Littrow configuration, wherein the grating is connected to a pivot arm to change not only the angle of the grating with respect to the incident light beam but also the cavity length in order to improve the mode hop performance of the arrangement.

One common problem for the known dielectric transmission type gratings in a Littrow configuration is a low reflectance to the $R_{-1}$ diffraction order. For example, for a binary grating formed in $SiO_2$, maximum value of reflectance in this direction is about 5-10%. However, reflectance needed in ECDL applications is practically at least 15%, and in special applications even 100%. Merimaa et al achieved nearly 20% by using a $TiO_2$ coating on the surface of the $SiO_2$ grating. However, an additional $TiO_2$ layer complicates the manufacturing process and, in practice, accurately controlling the coating process is very challenging. In addition, the optimal output of such a grating is achieved only for one polarisation state at a time. The gratings proposed so far for transmission type Littrow configurations either do not solve the problem of impractically high level of stray light into the $R_0$ and $T_{-1}$ diffraction orders resulting in a total efficiency of the system well below 100%.

**PURPOSE OF THE INVENTION**

The purpose of the present invention is to disclose an improved Littrow type light manipulation arrangement providing alleviation to the problems of the prior art.

**SUMMARY OF THE INVENTION**

The present invention is focused on a light manipulation arrangement comprising a light source and a transmission type diffraction grating, the light source being arranged to produce a light beam directed to the diffraction grating, the incident angle of the light beam and the grating geometry being adjusted to concentrate the incident light power to the $R_{-1}$ reflection diffraction order backwards to the direction of the incident light beam and to the $T_0$ transmission diffraction order through the diffraction grating.

Depending on the nature of the light source, the arrangement can comprise lenses, mirrors and other light guiding elements for directing the light beam to the diffraction grating. By the incident angle is meant the angle between the incident light beam and the normal of the plane in which the diffraction grating lies. The diffraction grating can be a surface relief grating or a volume grating.

Said direction of the $R_{-1}$ diffraction order backwards to the direction of incidence is achieved when the phase shift between light beams reflected to said direction from adjacent grating lines separated by a distance d equals to the multiple of the designed wavelength to achieve a constructive interference between said beams. A configuration fulfilling this condition is often known as a so called Littrow configuration.

Concentrating the incident light power to those two diffraction orders means that the most of the power is divided between said orders. Usually all output elsewhere is desired to be minimised. However, sometimes it is desired to produce a low power output also e.g. to the $T_{-1}$ diffraction order for monitoring purposes.

Designing the diffraction grating to provide the performance determined above can be performed by known optimising routines based on diffraction theory.

According to the present invention, the diffraction grating is of slanted type. Slanted type grating geometry means a grating geometry where, instead of the conventional grating structure having the ridges and grooves forming the grating lines perpendicular to the plane of the grating plane, the grating lines are tilted relative to the normal of the plane of the grating. Slanted gratings have earlier found to provide many advantageous features e.g. in light coupling applications for light guides.

Thus, the key principle of the present invention can be determined, for example, as the use of a slanted grating geometry in the diffraction grating in a Littrow type configuration. From a method point of view, the present invention concerns concentrating, in a transmission type Littrow configuration, the incident light power to the $R_{-1}$ reflection diffraction order backwards to the direction of the incident light beam and to the $T_0$ transmission diffraction order by a slanted type grating.

The key principle of the present invention is based on the observation by the inventors that by means of a slanted grating the imperfections of the prior art solutions can be to a great extent avoided. Firstly, by suitably selecting the arrangement parameters, very high diffraction efficiency, i.e. very low stray light outside the $R_{-1}$ and $T_0$ diffraction orders can be achieved. Theoretically, the arrangement according to the present invention is also designable for any desired values between 0 and 100% of diffraction efficiencies of those two useful diffraction orders. Moreover, even the highest reflection diffraction efficiencies are achieved with dielectric grating materials without any additional coatings, which makes the manufacturing of the grating simple and accurately controllable. As one of the most important advantages of the present invention, optimal operation of the arrangement is not limited to one particular state of polarisation only but, as is the case in one preferred embodiment, the arrangement can be optimised for operation with very high diffraction efficiency also for unpolarised light.

Preferably, the operation wavelength of the arrangement is adjustable, for example, by rotating or stretching the grating. By rotating the grating the incident angle and then also the wavelength to fulfill the Littrow condition is changed. Rotating the grating is a standard adjusting principle in tunable ECDLs. Instead of changing the incident angle, stretching alters the grating period. The final result is the same, i.e. the wavelength fulfilling the Littrow condition and thus providing the $R_{-1}$ diffraction order backwards in the direction of incidence is changed.

Preferably, the designed incident angle around which the grating possibly is rotatable is about 45 degrees. With this kind of angle the desired performance including, for example, restricting the diffraction into the lowest diffraction orders only is easiest to achieve. Due to the symmetry, 45 degrees also provides the most straightforward way to manufacture the mechanics of the arrangement. However, also other angles are possible, the most convenient range lying between 35 and 55 degrees.

The present invention is aimed at all applications where diffraction to the $R_{-1}$ and $T_0$ diffraction orders with predetermined proportions with a high total diffraction efficiency is desired. In one preferred embodiment the light source is a laser diode. In this embodiment, the arrangement can form an external cavity diode laser (External Cavity Diode Laser ECDL). Use of a slanted grating geometry enables sufficiently high reflection into the $R_{-1}$ diffraction order, thus significantly improving the performance of a EDCL in comparison with the prior art solutions. Another example of applications in which the present invention can provide advantages is the transmission type diffraction grating compressor used for recompressing the amplified pulses in a femtosecond fiber laser system.

The grating according to the present invention can be manufactured, in principle, in any material used for diffraction gratings. Standard manufacturing process steps including lithography, replication techniques etc. can be utilised. However, slanted geometry naturally set some special requirements to the manufacturing. One very good alternative particularly designed for mass production of slanted gratings by replication is disclosed in the applicant's earlier patent application WO 2007/057500.

**BRIEF DESCRIPTION OF THE DRAWINGS**

In the following, the present invention is described in more detail by means of the accompanying figures.

Figure 1 schematically shows the general principles of the light manipulation arrangement according to the present invention.

Figures 2 - 8 and table 1 show calculated results for one embodiment of the present invention.

Figure 9 and Table 2 show results of a real test arrangement according to one embodiment of the present invention.

**DETAILED DESCRIPTION OF THE INVENTION**

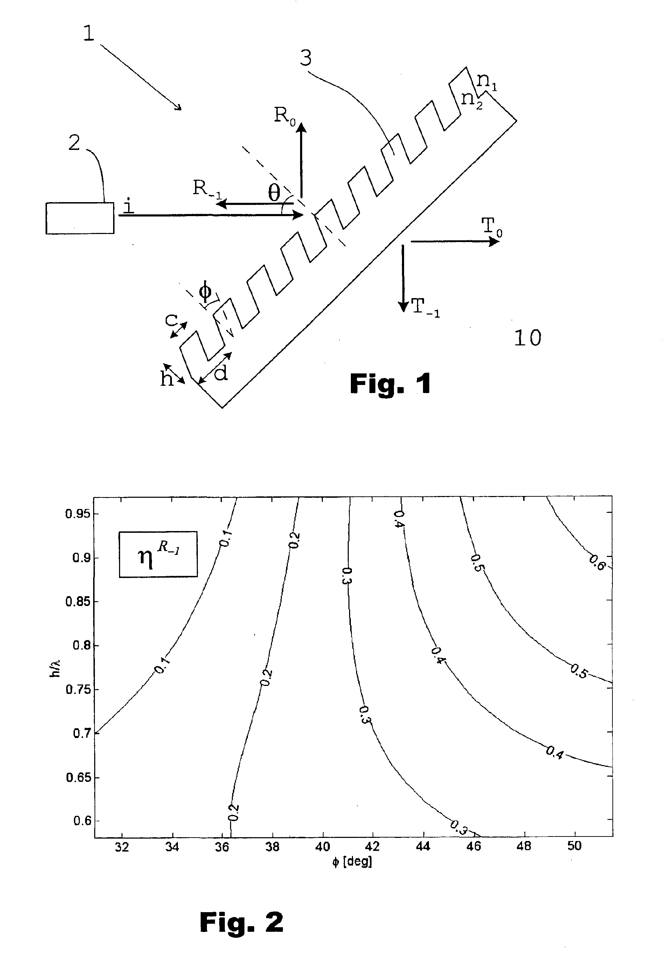

In the arrangement 1 of Fig 1 (not in scale), a light source 2, e.g. a laser diode, is arranged to produce a light beam i, possibly collimated and guided by collimating and guiding optics, directed to a slanted type diffraction grating 3 in a tilted incident angle $\theta$. The incident angle $\theta$ and the grating geometry is adjusted according to the first order Littrow configuration, i.e. to produce reflection into the $R_{-1}$ diffraction order backwards in the direction of the incident beam. A portion of the light is transmitted through the grating in the $T_0$ diffraction order. Diffraction into $R_0$ and $T_{-1}$ diffraction orders usually represent stray light to be minimised. In addition to the incident angle $\theta$, the other key parameters determining the operation of a grating according to Fig. 1 are:

grating period $d$
grating depth $h$
grating fill-factor $c$
grating slanted angle $\Phi$
ambient refractive index $n_1$
grating refractive index $n_2$.

As shown in Fig. 1, the grating slanted angle $\Phi$ means the angle between the centre line of the grating line ridge cross section and the normal of the plane of the grating substrate. In the exemplary grating of Fig. 1 the grating line ridge has a constant width. It is also possible, and from manufacturing point of view very useful, that the ridge narrows towards the top of it, the extreme case of this being a triangular grating.

A test arrangement was designed comprising a transmission type binary slanted grating manufactured into refractive index of $n_2=1.5$, the ambient being air with a refractive index $n_1 =1.0$, and the grating parameters fulfilling the Littrow configuration condition:

$$\theta = \arcsin \frac{\lambda}{2n_1 d} \, ,$$

where $\lambda$ is the illumination wavelength.

Incident angle of $\theta = 45°$ was selected. The design process was performed by optimising with a target to find suitable grating parameters for a given target diffraction efficiency $\eta^T$ to the $R_{-1}$ diffraction order by altering the grating parameters and by using a merit function to stop the optimisation. In the optimisation process, a rigorous electromagnetic theory as described by Turunen in "Diffraction theory of microrelief gratings", in Micro-optics, H.P.Herzig (Ed)., Taylor & Francis Inc., 1997, was used. The optimisation was carried out for TE, TM and unpolarised light. Here the unpolarised light is determined as $\eta_{UP} = (\eta_{TE}+\eta_{TM})/2$. The merit function used was $M = |\eta^T-\eta^{R-1}|+|100-\eta^T-\eta^{T0}|$ and the aim was to minimise the merit function.

Optimisation results for several target efficiencies in the range of $\eta^T = 10...100\%$ are shown in Table 1. The backside reflection of the substrate is not compensated from the transmitted order values. The results of Table 1 clearly shows that the $\eta^{R-1}$ can be chosen freely and almost all the rest of the energy is transmitted into the $T_0$ diffraction order. The losses into the $R_0$ and $T_{-1}$ diffraction orders are minimal. In comparison to the prior art solutions, these results achieved by a grating without any additional coatings and also for unpolarised light are superior.

Table 1.

| Polarisation | $\eta^T$ [%] | $h/\lambda$ | $\Phi$ [deg] | $c/d$ | $\eta^{R-1}$ [%] | $\eta^{T0}$ [%] | $\eta^{R0}$ [%] | $\eta^{T-1}$ [%] |
|---|---|---|---|---|---|---|---|---|
| UP | 10.00 | 0.76 | 37.76 | 0.51 | 9.93 | 88.40 | 0.89 | 0.77 |
| TE | 10.00 | 0.71 | 40.56 | 0.43 | 10.00 | 87.53 | 1.58 | 0.89 |
| TM | 10.00 | 0.67 | 47.17 | 0.30 | 9.97 | 90.00 | 0.01 | 0.01 |
| UP | 20.00 | 0.76 | 39.18 | 0.58 | 20.00 | 79.54 | 0.19 | 0.28 |
| TE | 20.00 | 0.77 | 38.82 | 0.58 | 20.00 | 79.40 | 0.14 | 0.46 |
| TM | 20.00 | 0.70 | 46.89 | 0.40 | 19.96 | 80.00 | 0.03 | 0.01 |
| UP | 30.00 | 0.78 | 41.19 | 0.63 | 29.59 | 70.00 | 0.18 | 0.24 |
| TE | 30.00 | 0.78 | 40.68 | 0.64 | 29.55 | 70.00 | 0.08 | 0.37 |
| TM | 30.00 | 0.76 | 44.33 | 0.53 | 29.83 | 70.00 | 0.17 | 0.00 |
| UP | 40.00 | 0.81 | 43.70 | 0.65 | 38.92 | 60.0 | 0.16 | 0.91 |

(continued)

| Polarisation | $\eta^T$ [%] | $h/\lambda$ | $\Phi$ [deg] | $c/d$ | $\eta^{R\text{-}1}$ [%] | $\eta^{T0}$ [%] | $\eta^{R0}$ [%] | $\eta^{T\text{-}1}$ [%] |
|---|---|---|---|---|---|---|---|---|
| TE | 40.00 | 0.82 | 42.96 | 0.67 | 38.37 | 60.00 | 0.09 | 1.53 |
| TM | 40.00 | 0.78 | 46.20 | 0.57 | 39.75 | 60.00 | 0.18 | 0.07 |
| UP | 50.00 | 0.89 | 45.44 | 0.70 | 48.43 | 50.00 | 0.18 | 1.40 |
| TE | 50.00 | 0.88 | 44.71 | 0.71 | 47.30 | 50.00 | 0.08 | 2.62 |
| TM | 50.00 | 0.92 | 54.75 | 0.76 | 49.88 | 50.00 | 0.08 | 0.05 |
| UP | 60.00 | 0.97 | 49.19 | 0.73 | 58.51 | 40.00 | 0.84 | 0.65 |
| TE | 60.00 | 0.95 | 49.79 | 0.74 | 57.45 | 40.00 | 1.01 | 1.54 |
| TM | 60.00 | 0.93 | 53.68 | 0.70 | 59.89 | 40.00 | 0.04 | 0.07 |
| UP | 70.00 | 1.41 | 46.16 | 0.67 | 69.18 | 30.00 | 0.09 | 0.73 |
| TE | 70.00 | 1.43 | 45.66 | 0.70 | 68.66 | 30.00 | 0.03 | 1.31 |
| TM | 70.00 | 1.43 | 46.78 | 0.64 | 69.83 | 30.00 | 0.13 | 0.04 |
| UP | 80.00 | 1.57 | 47.53 | 0.75 | 79.11 | 20.00 | 0.33 | 0.56 |
| TE | 80.00 | 1.59 | 50.07 | 0.79 | 79.93 | 20.00 | 0.04 | 0.03 |
| TM | 80.00 | 1.57 | 47.56 | 0.78 | 78.43 | 20.00 | 0.38 | 1.19 |
| UP | 90.00 | 2.20 | 47.31 | 0.79 | 89.36 | 10.00 | 0.24 | 0.40 |
| TE | 90.00 | 2.18 | 46.97 | 0.78 | 88.89 | 10.00 | 0.24 | 0.87 |
| TM | 90.00 | 2.28 | 47.40 | 0.80 | 89.99 | 9. 97 | 0.03 | 0.01 |
| UP | 100.00 | 2.54 | 50.74 | 0.70 | 96.53 | 1.42 | 1.02 | 1.03 |
| TE | 100.00 | 4.18 | 45.59 | 0.95 | 99.99 | 0.00 | 0.00 | 0.00 |
| TM | 100.00 | 2.56 | 49.69 | 0.72 | 95.46 | 1.46 | 1.32 | 1.75 |

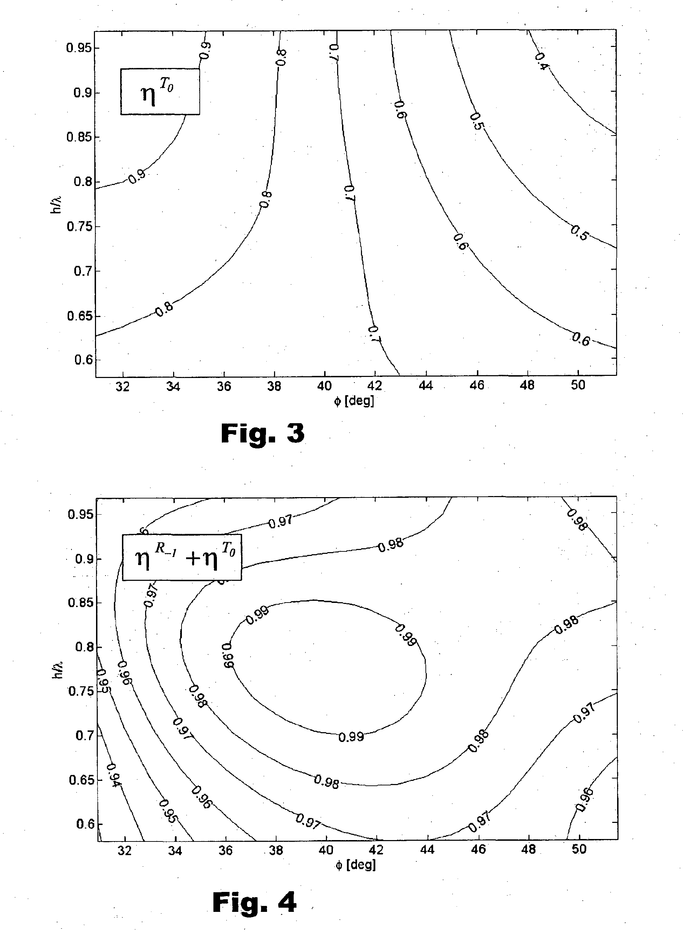

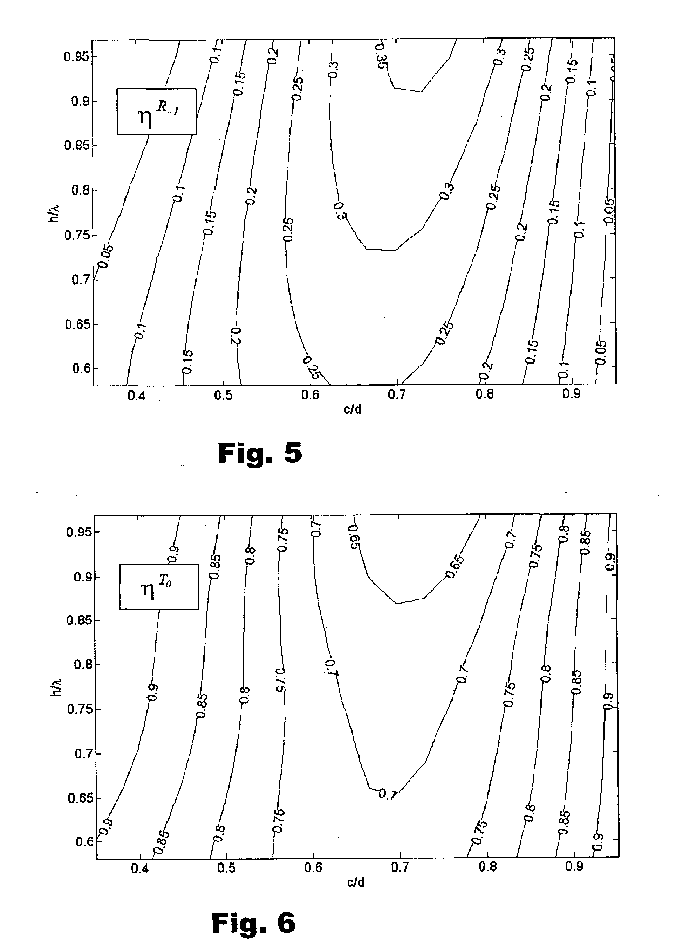

The reflection value of $\eta^{R\text{-}1} = 30\%$ with unpolarised light was chosen for a further study because this kind of reflection gives a good mode locking in most of the external cavity laser applications. In the further study, a grating manufacturing error analysis was performed. The grating efficiencies $\eta^{R\text{-}1}$, $\eta^{T0}$, and $\eta^{R\text{-}1}+\eta^{T0}$ as a function of the grating depth $h$ and the slanted angle $\Phi$ were simulated. The results are shown in Figs. 2 - 4. As can be seen in those figures, the arrangement is very tolerant for possible inaccuracies in the grating manufacturing. The trend is that the increase of the slanting angle increases the $\eta^{R\text{-}1}$ efficiency. Furthermore, a tolerance analysis for those grating efficiencies was performed also as a function of the grating depth $h$ and the fill-factor c, the results being shown in Figs. 5-7. Again, the figures show that the arrangement is tolerant for quite large errors in the realised grating structure providing thus a good working window for the manufacturing processes.

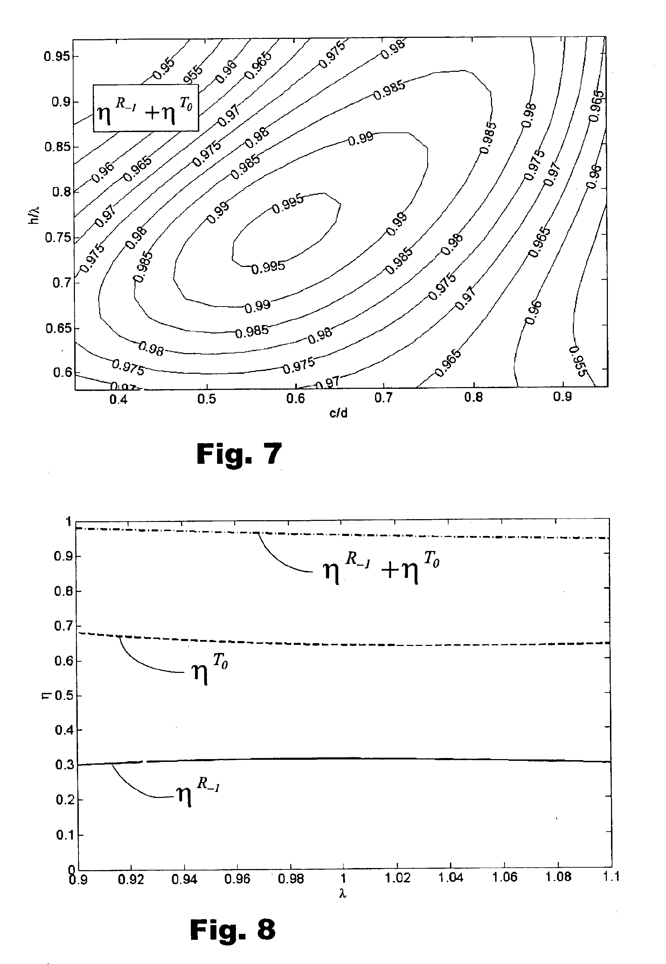

In the external cavity applications, the tunability of the grating is one of the most important issues. For this purpose, a slanted grating was simulated in which the target efficiency of $\eta^T = 0.3$ was given for three wavelengths and the merit function was chosen as $M = \left| \eta^T - \eta^{R\text{-}1}_{0.9\lambda} \right| + \left| \eta^T - \eta^{R\text{-}1}_{1.0\lambda} \right| + \left| \eta^T - \eta^{R\text{-}1}_{1.1\lambda} \right|$. As a result from the optimisation,

the grating parameters $h/\lambda = 0.56$, $\Phi = 50.75°$, and $c = 0.61$ were obtained with the efficiencies $\eta^{R\text{-}1}$, $\eta^{T0}$, and $\eta^{R\text{-}1} +\eta^{T0}$ as function of illumination wavelength $\lambda$ shown in Fig. 8. In this case, very flat efficiencies into $R_{-1}$ and $T_0$ diffraction orders are obtained, which makes the tuning of the laser very stable and predictable and keeps the laser locked when the grating is rotated. The wavelength range used in the optimisation presents over 5° tuning area which is much more than is needed for most of the applications.

In addition to the theoretical calculations described above, also test gratings were manufactured for confirming the predicted operation of the arrangement according to the present invention. Reflection value of $\eta^{R\text{-}1} = 0.15$ for wavelength. $\lambda = 633\ nm$ was chosen as the target of the test arrangement. Said wavelength is one of the most suitable ones for the external cavity diode laser applications. The reflection value of 15 % for its part is high enough for a good laser stability while providing a maximum output.

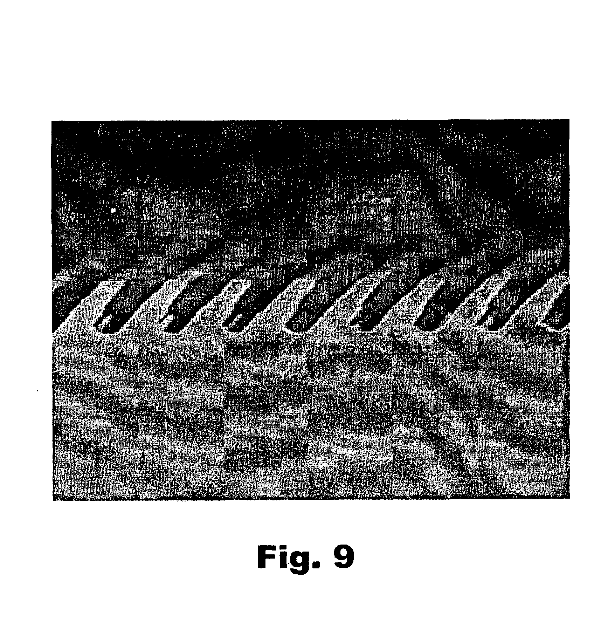

The test gratings were manufactured by using interferometric recording, chlorine etching and reactive ion beam etching. The main details of the manufacturing process are described by Levola et al in "Replicated slanted gratings with a high refractive index material for in and outcoupling of light", Opt. express, 15, 2067-2074 (2007). The main difference in comparison to the process of the article was that now the target grating period was $d = 460\ nm$. The grating material was $SiO_2$ with a refractive index $n=1.49$. A SEM image of a realised grating is shown in Figure 9. The grating depth was $h = 390\ nm$. As is seen in the figure, the cross section of the grating line ridge narrows towards the top of the ridge, the slanting angles of the two faces of the ridge being *45°* and *38°*. After finalising the gratings, the diffraction efficiencies for unpolarised light were measured by a simple laser system with an illumination angle of *θ=43.47°*.

In addition to measuring the test arrangement performance, the test grating profile was measured and, based on this measured profile, also the theoretical performance of the test arrangement was calculated. The experimental and theoretical diffraction efficiencies are collected in Table 2. There was no antireflection coating on the backside of the test gratings. Therefore, the Fresnel reflection losses for the transmitted beams are taken into account in the experimental values of the table. As can be seen in Table 2, the measured performance agrees well with the target. Secondly, there is a very good agreement between the measured and the theoretical values calculated on the basis of the test grating profile. These results clearly confirm the feasibility of the present invention.

Table 2.

| | $\eta^{R_{-1}}$ | $\eta^{T_0}$ | $\eta^{R_0}$ | $\eta^{T_{-1}}$ |
|---|---|---|---|---|
| Experimental | 16.2 | 80.4 | 1.0 | 2.4 |
| Theoretical | 15.5 | 81.1 | 1.3 | 2.1 |

It is obvious for a person skilled in the art that the basic idea of the invention may be implemented in various ways. The invention and its embodiments are thus not limited to the examples described above but they may vary within the scope of the claims. For example, the grating can be manufactured in any material. The grating material can also differ from that of the grating substrate. One possibility is to form the grating as a stack of thin films. Contrary to the examples above, the grating can be alternatively formed on the backside of the substrate. Also an antireflection coating can be used on the substrate surface to further enhance the arrangement performance.

**Claims**

1. A light manipulation arrangement (1) comprising a light source (2) and a transmission type diffraction grating (3), the light source being arranged to produce a light beam (i) directed to the diffraction grating, the incident angle ($\theta$) of the light beam and the grating geometry being adjusted to concentrate the incident light power to the $R_{-1}$ reflection diffraction order backwards to the direction of the incident light beam and to the $T_0$ transmission diffraction order through the diffraction grating, **characterised in that** the diffraction grating (3) is of slanted type.

2. An arrangement (1) according to claim 1, wherein the diffraction grating (3) is optimised for unpolarised light.

3. An arrangement (1) according to claim 1 or 2, wherein the operation wavelength of the arrangement (1) is adjustable, for example, by rotating or stretching the diffraction grating (3).

4. An arrangement (1) according to any of claims 1 to 3, wherein the incident angle $\theta$ is in a range of 35 - 55 degrees, preferably about 45 degrees.

5. An arrangement (1) according to any of claims 1 to 4, wherein the light source (2) is a laser diode.

**Patentansprüche**

1. Lichtmanipulationsanordung (1), die eine Lichtquelle (2) und ein Transmissionsbeugungsgitter (3) umfasst, wobei die Lichtquelle dafür ausgelegt ist, ein Lichtbündel (i) zu erzeugen, das auf das Beugungsgitter gerichtet ist, wobei der Einfallswinkel (θ) des Lichtbündels und die Gittergeometrie dafür eingestellt sind, die einfallende Lichtleistung auf die Reflexionsbeugungsordnung R$_{-1}$ zurück zu der Richtung des einfallenden Lichtbündels und auf die Transmissionsbeugungsordnung T$_\theta$ durch das Beugungsgitter zu konzentrieren, **dadurch gekennzeichnet, dass** das Beugungsgitter (3) vom geneigten Typ ist.

2. Anordnung (1) nach Anspruch 1, wobei das Beugungsgitter (3) für unpolarisiertes Licht optimiert ist.

3. Anordnung (1) nach Anspruch 1 oder 2, wobei die Betriebswellenlänge der Anordnung (1) z. B. durch Drehen oder Dehnen des Beugungsgitters (3) einstellbar ist.

4. Anordnung (1) nach einem der Ansprüche 1 bis 3, wobei der Einfallswinkel $\theta$ in einem Bereich von 35-55 Grad, vorzugsweise bei etwa 45 Grad, liegt.

5. Anordnung (1) nach einem der Ansprüche 1 bis 4, wobei die Lichtquelle (2) eine Laserdiode ist.

**Revendications**

1. Agencement de manipulation de lumière (1) comprenant une source de lumière (2) et un réseau de diffraction de type à transmission (3), la source de lumière étant agencée pour produire un faisceau de lumière (i) dirigé vers le réseau de diffraction, l'angle incident ($\theta$) du faisceau de lumière et la géométrie de réseau étant réglés pour concentrer la puissance de lumière incidente à l'ordre de diffraction de réflexion $R_{-1}$ à l'opposé du sens du faisceau de lumière incident et à l'ordre de diffraction de transmission $T_0$ par l'intermédiaire du réseau de diffraction, **caractérisé en ce que** le réseau de diffraction (3) est du type oblique.

2. Agencement (1) selon la revendication 1, dans lequel le réseau de diffraction (3) est optimisé pour une lumière non polarisée.

3. Agencement (1) selon la revendication 1 ou 2, dans lequel la longueur d'onde de fonctionnement de l'agencement (1) est réglable, par exemple, par rotation ou étirement du réseau de diffraction (3).

4. Agencement (1) selon l'une quelconque des revendications 1 à 3, dans lequel l'angle incident $\theta$ est compris dans une plage allant de 35 à 55 degrés, de préférence est d'environ 45 degrés.

5. Agencement (1) selon l'une quelconque des revendications 1 à 4, dans lequel la source de lumière (2) est une diode laser.

**Fig. 1**

**Fig. 2**

**Fig. 3**

**Fig. 4**

Fig. 5

Fig. 6

**Fig. 7**

**Fig. 8**

**Fig. 9**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20070223554 A

- WO 2007057500 A

**Non-patent literature cited in the description**

- Compact external-cavity diode laser with a novel transmission geometry. *Optics Communications,* 2000, vol. 174, 175-180
- Stretching-tunable external-cavity laser locked by an elastic silicone grating. *Optics Express,* vol. 14 (25), 11982-11986

- Diffraction theory of microrelief gratings. **TURUNEN.** Micro-optics. Taylor & Francis Inc, 1997
- **LEVOLA et al.** Replicated slanted gratings with a high refractive index material for in and outcoupling of light. *Opt. express,* 2007, vol. 15, 2067-2074